# EUROPÄISCHE PATENTSCHRIFT

(11) **EP 2 228 895 B1**
(45) Veröffentlichungstag und Bekanntmachung des Hinweises auf die Patenterteilung: **26.12.2012**
(21) Anmeldenummer: 09003353.1
(22) Anmeldetag: 09.03.2009
(51) Int. Cl.: H02M 7/48, H01H 47/00

(54) **Wechselrichterschaltung mit Trennstelle**
Inverter with utility grid interface
Onduleur avec interface au réseau d'alimentation

(43) Veröffentlichungstag der Anmeldung: 15.09.2010
(73) Patentinhaber: SMA Solar Technology AG, 34266 Niestetal (DE)
(72) Erfinder: Wolf, Henrik, 34123 Kassel (DE); Prior, Oliver, 34431 Marsberg (DE); Schröder, Thomas, 34117 Kassel (DE)
(74) Vertreter: Specht, Peter

(56) Entgegenhaltungen:
- EP-A- 1 538 651
- EP-A- 1 965 483
- DE-A1-102005 014 122
- DE-A1-102006 030 751
- JP-A- 2003 116 222
- US-B1- 6 239 997

## Beschreibung

Die Erfindung betrifft eine Wechselrichterschaltung nach dem Oberbegriff des Anspruches 1.

Wechselrichter dienen der Umwandlung einer Gleichspannung in Wechselspannung und umfassen eine aus Halbleitern bestehende Brückenschaltung, die eine DC-AC-Wandlerfunktion übernimmt.

Die Gleichspannung kann dabei eine Gleichspannungsquelle, wie z. B. eine Batterie sein. Häufig ist die Gleichspannungsquelle ein Photovoltaikgenerator, der Energie in ein Energieversorgungsnetz einspeisen soll.

Photovoltaikwechselrichter für die Installation auf relativ kleinen Flächen sollen eine möglichst kompakte, handliche und leichte Bauweise aufweisen, damit sie ohne großen Werkzeugaufwand montiert werden können. Ein solcher Wechselrichter besitzt ein Gewicht und Abmaße, die es erlauben, dass ein oder maximal zwei Personen das Gerät im Wesentlichen ohne Hilfsmittel transportieren und montieren können.

Innerhalb des Gehäuses müssen die erforderlichen elektronischen Komponenten, Halbleiter, Filterdrosseln, Kondensatoren und dergleichen untergebracht werden. Je höher die zulässige Ausgangsleistung des Gerätes ist, umso größer sind auch die Bauteile dimensioniert. Das heißt, wenn das Gerät kompakt sein soll, hat dies ein eng bestücktes Gehäuse bzw. Gerät zur Folge.

Für die Zulassung zur netzparallelen Einspeisung müssen Photovoltaikwechselrichter jedoch gemäß einschlägiger Normen und Vorschriften (z. B. DIN V VDE V 0 1 2 6 - 1 - 1) über eine selbsttätige Schaltstelle zum Netz verfügen, deren Hauptaufgabe in der Verhinderung einer unbeabsichtigten Einspeisung in ein Teilnetz bzw. ein Inselnetz besteht und die damit eine Schutzfunktion ausübt.

Um ein zusätzliches Gehäuse oder anderes zusätzliches Montagehilfsmittel zu sparen, ist bekannt, die Schaltstelle in das bereits vorhandene Wechselrichtergehäuse zu integrieren, was wiederum die Gehäuseabmessungen vergrößert.

Zudem fordert die erwähnte Norm, dass diese Schaltstelle den Einspeisebetrieb pro aktiven Leiter durch zwei unabhängig voneinander zu betätigende, in Serie liegende Schalter unterbrechen muss. Des Weiteren muss die Trennung dergestalt aufgebaut sein, dass auch im Fall des Auftretens eines einzelnen Fehlers die Sicherheitsfunktion gewahrt bleibt.

Gängige Praxis für die Erfüllung dieser Vorgaben ist es, bis zu einem Bereich mittlerer Leistungen von mehreren 10kW, einpolige Relais mit entsprechendem Schaltvermögen einzusetzen, die alle jeweils über eine eigene Ansteuerung einschließlich der dazugehörigen Überwachungseinrichtung verfügen müssen.

Dreipolige Relais bzw. Schütze sind nur für größere Leistungsbereiche verfügbar und benötigen einen gegenüber einlötbaren Relais erheblich größeren Bauraum. Ferner ist deren Montage aufwendig, fehleranfällig und für Großserienfertigung nicht geeignet. Für eine normkonforme Lösung müssten daher sechs einpolige Relais eingesetzt werden, was nicht nur teuer ist, sondern auch Einbauraum kostet.

Der Erfindung liegt die Aufgabe zugrunde, eine Wechselrichterschaltung zu schaffen, die einerseits eine kompakte Ausführung des Wechselrichters erlaubt und andererseits aber die entsprechenden Normen erfüllt.

Diese Aufgabe wird durch die kennzeichnenden Merkmale des Anspruches 1 in Verbindung mit seinen Oberbegriffsmerkmalen gelöst.

Die vorliegende Erfindung schafft eine Schaltung, die es ermöglicht, einen dreiphasigen Photovoltaikwechselrichter normkonform bereitzustellen, und zwar mit nur drei zweipoligen Relais, was kostengünstiger und kompakter ist als eine Lösung mit sechs einpoligen Relais.

Durch die erfindungsgemäße Verschaltung dreier zweipoliger Relais wird zudem eine Großserien taugliche Lösung für die vorgeschriebene Trennstelle zum Einspeisepunkt bereitgestellt, die trotz eines minimalen Bauteileinsatzes auch im Falle eines Einzelfehlers ihre Schutzfunktion aufrecht erhalten kann.

Weitere vorteilhafte Ausgestaltungen der Erfindung sind in den Unteransprüchen beschrieben.

In einer vorteilhaften Weiterbildung der erfindungsgemäßen Schaltung ist vorgesehen, dass die Relaisschaltung als selbsttätige Schaltstelle zur Verhinderung einer unbeabsichtigten Einspeisung in ein Teil- oder Inselnetz ausgeführt ist. In Kombination mit einer Inselnetzerkennung kann der Wechselrichter vom ausgefallenen Netz getrennt werden, so dass durch die Wechselrichterspannung keine Personengefährdung bei Wartungsarbeiten ausgeht.

Vorteilhaft ist, wenn die Relaisschaltung in einem Wechselrichtergehäuse integriert ist. Der DC-AC-Wandler und die Trenneinrichtung bilden eine Einheit. Die Gehäuseabmessungen müssen durch die kleine Anzahl der Relais nur unwesentlich geändert werden oder können gleich bleiben. Möglich ist aber auch, die Anordnung der Relais in einem Zusatzgehäuse. Eine platzsparende Lösung ist verwirklicht, wenn jedes Relais als ein auf einer Schaltplatine einlötbares Relais (Printrelais) ausgeführt ist.

Eine transformatorlose Ausführung des Wechselrichters ist nicht nur leicht und sehr kompakt, sondern ermöglicht durch die Relais eine galvanische Trennung eines Gleichspannungsgenerators. Insgesamt ist der Wechselrichter mit nur drei Relais und ohne Transformator sehr kompakt.

Zweckmäßigerweise werden Freischaltstellen eingesetzt, um normgerecht einen netzparallelen Einspeisebetrieb von mehreren Wechselrichtern zu erlauben. Jeder Wechselrichter hat vorzugsweise eine eigene Freischaltstelle mit drei Relais.

Bei einer weiteren vorteilhaften Ausführung der Erfindung ist jede Relaisspule durch eine Ansteuerschaltung von einer Steuereinheit betätigbar. Die Ansteuerschaltung kann als Relais-Treiberschaltung mit steuerbaren Halbleitern wie Transistoren ausgeführt sein. Für einen sicheren Betrieb und Vermeidung von unerwünschten Schaltzuständen bei Fehlern umfasst die Ansteuerschaltung für jede Relaisspule ein UND-Gatter, bei dem ein Gatter-Eingang mit der Ansteuerschaltung und ein anderer Gatter-Eingang mit einer Watchdog-Einrichtung verbunden ist, so dass jede Relaisspule nur betätigt wird, wenn sowohl ein Setzsignal als auch ein Unterbrechungssignal der Watchdog-Einrichtung gleichzeitig vorhanden sind.

Die Betriebsführung (BFS) bzw. die Steuereinheit wird von der Watchdog-Einrichtung permanent überwacht. Die Relaiskontakte, die als Schließer ausgeführt sind, können nur geschlossen werden, wenn sowohl die Steuereinheit als auch die Watchdog-Einrichtung Signale senden, die über die UND-Gatter an die Relais-Ansteuerschaltung weitergegeben werden. Da jedes Relais pro Phase nur einen Kontakt besitzt, führt ein einzelnes Ansteuersignal noch nicht zu einer galvanischen Verbindung des Wechselrichters mit dem Netz. Um im Betrieb die Funktionsfähigkeit der Relais-Ansteuerung zu überwachen, werden für hinreichend kurze Zeiten die Relais-Steuersignale unterbrochen und die Reaktionen an den Steuerspulen durch ein Relais Test Signal von der Steuereinheit ausgewertet. Hinreichend kurz bedeutet hier, dass innerhalb des Wegfalls des Ansteuersignals keine mechanische Reaktion des Kontaktes erfolgen kann, jedoch elektrisch ein Funktionstest möglich ist.

Anhand der Zeichnungen wird die Erfindung nachstehend beispielhaft näher erläutert.
- Figur 1: zeigt eine schematische Darstellung einer dreiphasigen Netzrelais-Verschaltung;
- Figur 2: zeigt eine Darstellung eines Sicherheitskonzeptes der dreiphasigen Netzrelais-Verschaltung.

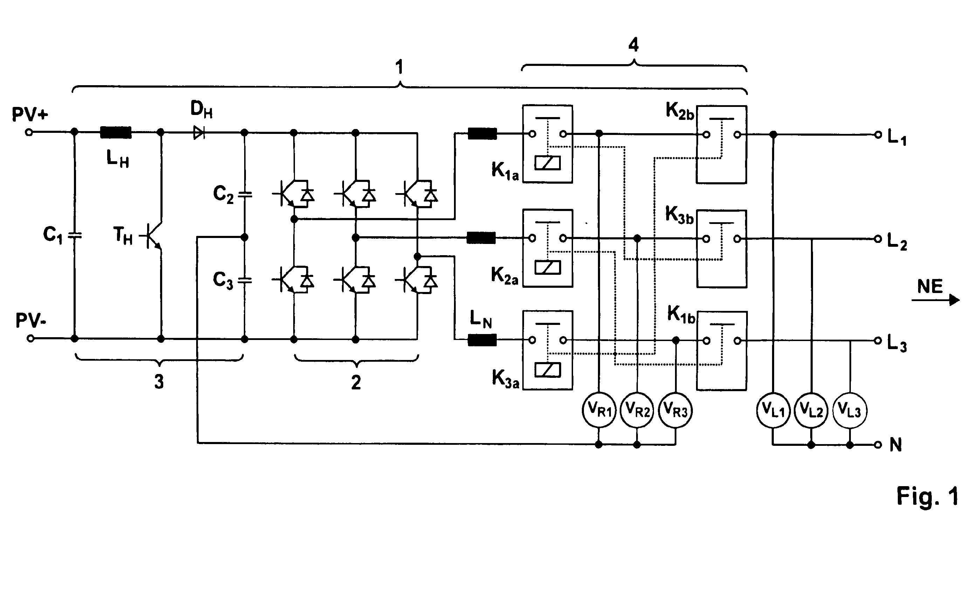

Figur 1 zeigt einen Photovoltaikwechselrichter 1 mit einer Wechselrichterschaltung zur Umwandlung einer Photovoltaik-Gleichspannung in eine dreiphasige netzfrequente Wechselspannung. Der Wechselrichter umfasst eine Voll-Brückenschaltung 2 mit sechs Halbleiterschaltern und parallelen Freilaufdioden, die einen DC/AC-Wandler bilden. Zwischen den Generatoranschlüssen PV+ und PV- und der Brücke 2 ist ein Pufferkondensator C1 sowie ein Hochsetzsteller 3 mit einer Drossel LH, einem Schalter TH und einer Diode DH geschaltet. Zwischen dem Hochsetzsteller sind zwei identische Zwischenkreis-Kondensatoren C2, C3 in Reihenschaltung angeordnet, wobei an ihrem Verknüpfungspunkt ein Spannungsabgriff für Spannungen VR1, VR2 und VR3 erfolgt. Diese Spannungen werden zur Funktionsüberwachung einer Trenneinrichtung gemessen. Der Verknüpfungspunkt dient zum Definieren eines neutralen Spannungspunktes. Zwischen der Trenneinrichtung und dem DC/AC-Wandler befindet sich noch ein Filter, insbesondere mit drei Filterdrosseln LN.

Weiterhin zeigt Figur 1 eine zwischen dem DC/AC-Wandler und einem Energieversorgungsnetz NE angeordnete Relaisschaltung, die als Schaltstelle 4 zur galvanischen Trennung für aktive Leiter L1, L2, L3 ausgeführt ist. Die Relais R1 - R3 haben vorzugsweise Schließerkontakte.

Das Netz NE ist zudem mit einem N-Leiter versehen, wobei die Leiterspannungen VL1, VL2, VL3 gegen N ebenfalls zur Funktionsüberwachung gemessen werden.

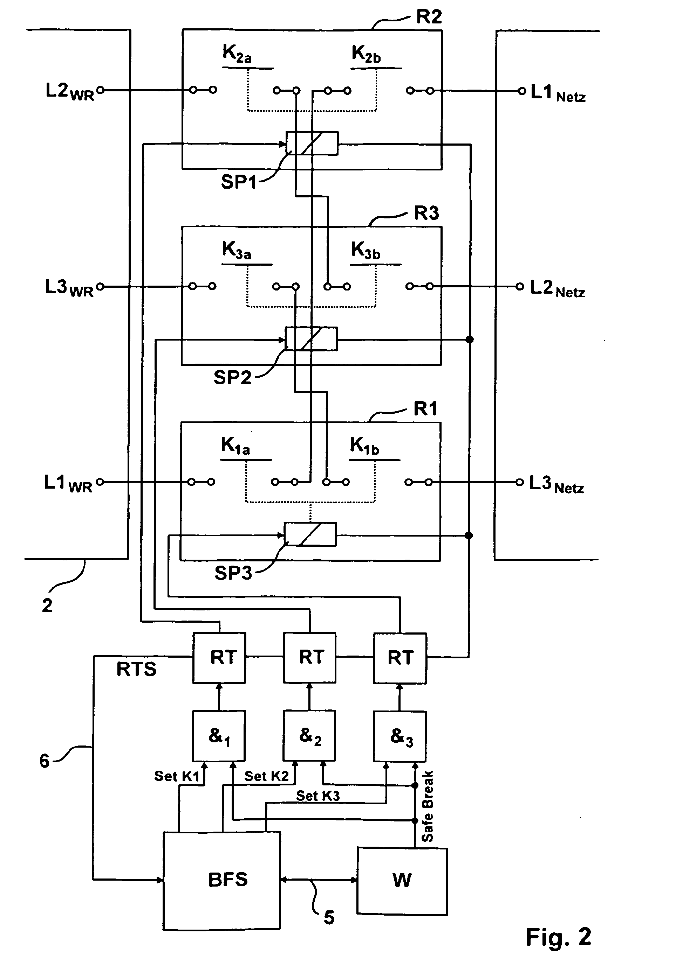

Erfindungsgemäß weist die Relaisschaltung nur drei zweipolige Relais R1, R2, R3 auf (Figur 2). Jedes Relais R1, R2, R3 hat eine Steuerspule Sp1, Sp2, Sp3 und zwei der Steuerspulen Sp1, Sp2, Sp3 zugeordnete Relaiskontakte K1 a, K1 b; K2a, K2b; K3a, K3b.

Nur ein Relaiskontakt, z. B. K1a, eines Relais, z. B. R1, ist in Reihe mit einem Relaiskontakt, z. B. K2b, eines der beiden anderen Relais verbunden. In diesem Fall ist der zweite Schaltkontakt K2b des Relais R2, das der Phase L1 zugeordnet ist, in Reihe mit dem ersten Schaltkontakt K1a des ersten Relais R1 (Phase L1) geschaltet. Die Kontakte K1a und K2b liegen in Reihe. Möglich ist auch, dass die Kontakte, z. B. K1 a und K3b, in Reihe liegen, jedoch dürfen die Kontakte desselben Relais, z. B. K1 a und K1 b, nicht in Reihe liegen.

Für die Phase L2 sind die Kontakte K2a und K3b in Reihenschaltung bzw. für L3 die Kontakte K3a und K1 b in Reihenschaltung, wie Figur 1 zeigt.

Pro aktiven Leiter L1, L2, L3 sind immer zwei unabhängig zu betätigende Relaiskontakte vorhanden.

In Figur 1 sind die Kontakte der unterschiedlichen Relais zeichnerisch hintereinander dargestellt (z. B. K1 a mit K2b).

Werden alle Relaisspulen Sp1 - Sp3 gleichzeitig betätigt und verschweißt, beispielsweise der erste Kontakt K1a des ersten Relais R1, dann besteht dennoch eine galvanische Trennung, weil infolge der Reihenschaltung die Trennung durch den intakten Kontakt K2b erfolgt. Auch wenn der Kontakt K1 b durch die Schweißverbindung der Kontaktes K1a nicht öffnet, so sorgt der geöffnete Kontakt K2b für die erforderliche Trennung.

Wie Figur 2 zeigt, sind die Relaisspulen Sp1 - Sp3 jeweils durch Relaistreiber bzw. Ansteuerschaltungen RT mit einem Ausgang eines UND-Gatters verbunden. Eines der Eingänge des UND-Gatters ist mit einer Steuereinheit BFS (Betriebsführung) für die Relais R1 - R3 durch eine Leitung verbunden, die ein Setzsignal SET_K1, SET_K2 bzw. SET_K3 führt. Der andere UND-Eingang ist durch ein Sicherheitssignal SAFE-BREAK einer Watchdog-Einrichtung W aktivierbar. Die Watchdog-Einrichtung W ist mit der Steuereinheit BFS durch eine Leitung 5 verbunden, die ein Prüfsignal CHECK geben kann. Die Relais-Treiber sind zudem durch die Leitung 6 mit der Steuereinheit BFS verbunden, wobei die Leitung 6 ein Relais Testsignal RTS geben kann.

An den Relaistreibern bzw. der Ansteuerschaltung RT werden Relaissteuersignale durch das Testsignal RTS für eine so kurze Zeit unterbrochen, dass keine Kontakttrennung erfolgt, wobei die Reaktionen auf das Testsignal RTS an den Steuerspulen Sp1, Sp2, Sp3 von der Steuereinheit BFS ausgewertet wird. Dadurch werden die Relaistreiber überprüft.

Zur Funktionsprüfung dient die Spannungsmessung der Spannungen VR1 - VR3 und VL1 - VL3.

Die gezeigte Überwachungsschaltung hat folgende Vorteile:

Fällt die Steuereinheit BFS aus, unterbindet die Watchdog-Einrichtung W ein Schließen der Relais R1 - R3. Fällt die Watchdog-Einrichtung W aus, unterbindet die Steuereinheit BFS ein Schließen der Relais R1 - R3. Fällt ein Logik-Gatter (UND) aus, registriert die Steuereinheit BFS diesen Fehler durch die Relais R1 - R3 Test Signale RTS .

Gleiches gilt für den Fall, dass ein oder mehrere Relaistreiber bzw. Ansteuerschaltungen RT ausfallen.

Durch die gewählte Verschaltung sind auch bei einem Einzelfehler niemals beide Relais innerhalb einer Phase geschlossen.

Die Erfindung ist nicht auf dieses Beispiel beschränkt, so kann anstatt einer Vollbrücke auch eine Halbbrücke, eine unterschiedliche Kondensator- und Filteranordnung (C1 - C3, LN), oder eine andere Anpassstufe 3 ausgewählt werden.

Der Begriff Relais umfasst hier jede eine Steuerspule und mechanische Schaltkontakte umfassende Vorrichtung, also auch ein Schütz.

### Bezugszeichenliste

- 1.: Photovoltaik-Wechselrichter
- 2.: Voll-Brückenschaltung
- 3.: Hochsetzsteller
- 4.: Schaltstelle
- 5.: Erste Leitung
- 6.: Zweite Leitung
- PV+, PV-: Generatoranschlüsse
- LH: Drossel
- TH: Schalter
- DH: Diode
- C1: Pufferkondensator
- C2, C3: Zwischenkreis-Kondensatoren
- VR1 - VR3: Spannungen
- NE: Energieversorgungsnetz
- LN: Filterdrossel
- L1 - L3: Leiter
- R1 - R3: Relais
- VL1 - VL2: Leiterspannungen
- N: Neutralleiter
- K1a - K3a: Erste Relaiskontakte
- K1b - K3b: Zweite Relaiskontakte
- Sp1 - Sp3: Relaisspulen
- RT: Ansteuerschaltung
- BFS: Steuereinheit
- SET_K1 - SET_K3: Setzsignal
- RTS: Testsignal
- W: Watchdog-Einrichtung

## Patentansprüche

1. Wechselrichterschaltung zur Umwandlung einer Gleichspannung in eine dreiphasige netzfrequente Wechselspannung, mit einer zwischen einem DC/AC-Wandler und einem Energieversorgungsnetz (NE) angeordneten Relaisschaltung, die als Schaltstelle (4) zur galvanischen Trennung für aktive Leiter (L1, L2, L3) ausgeführt ist, **dadurch gekennzeichnet,**
**dass** die Relaisschaltung drei zweipolige Relais (R1, R2, R3) aufweist, wobei jedes Relais (R1, R2, R3) eine Steuerspule (Sp1, Sp2, Sp3) und zwei jeweils einer Steuerspule (Sp1, Sp2, Sp3) zugeordnete Relaiskontakte (K1a, K1b; K2a, K2b; K3a, K3b) umfasst,
**dass** jeweils nur ein Relaiskontakt (K1 a) eines Relais (R1) in Reihe mit einem Relaiskontakt (K2b) eines der beiden anderen Relais (R2) verbunden ist,
so dass pro aktiven Leiter (L1, L2, L3) immer zwei unabhängig zu betätigende Relaiskontakte (K1 a, K2b) vorhanden sind.

2. Wechselrichterschaltung nach Anspruch 1,
**dadurch gekennzeichnet,**
**dass** die Relaisschaltung als selbsttätige Schaltstelle (4) zur Verhinderung einer unbeabsichtigten Einspeisung in ein Teil- oder Inselnetz ausgeführt ist.

3. Wechselrichterschaltung nach Anspruch 1 oder 2,
**dadurch gekennzeichnet,**
**dass** die Relaisschaltung in einem Wechselrichtergehäuse integriert ist.

4. Wechselrichterschaltung nach einem der vorhergehenden Ansprüche,
**dadurch gekennzeichnet,**
**dass** jedes Relais (R1, R2, R3) als ein auf einer Schaltplatine einlösbares Relais ausgeführt ist.

5. Wechselrichterschaltung nach einem der vorhergehenden Ansprüche,
**gekennzeichnet durch**
eine transformatorlose Ausführung.

6. Wechselrichterschaltung nach einem der vorhergehenden Ansprüche,
**dadurch gekennzeichnet,**
**dass** jede Relaisspule (Sp1, Sp2, Sp3) gesondert durch eine Ansteuerschaltung (RT) von einer Steuereinheit (BFS) betätigbar ist.

7. Wechselrichterschaltung nach Anspruch 6,
**dadurch gekennzeichnet,**
**dass** die Ansteuerschaltung (RT) für jede Relaisspule (Sp1, Sp2, Sp3) ein UND-Gatter umfasst, bei dem ein Gatter-Eingang mit der Ansteuerschaltung (RT) und ein anderer Gatter-Eingang mit einer Watchdog-Einrichtung (W) verbunden ist, so dass jede Relaisspule (Sp1, Sp2, Sp3) nur betätigt wird, wenn sowohl ein Setzsignal (SET K1, SET K2, SET K3) der Steuereinheit (BFS), als auch ein Unterbrechungssignal (SAFE-BREAK) der Watchdog-Einrichtung gleichzeitig vorhanden sind.

8. Wechselrichterschaltung nach Anspruch 7,
**dadurch gekennzeichnet,**
**dass** die Steuereinheit (BFS) von der Watchdog-Einrichtung (W) permanent überwacht wird.

9. Wechselrichterschaltung nach Anspruch 7 oder 8,
**dadurch gekennzeichnet,**
**dass** jede Ansteuerschaltung (RT) durch ein Testsignal (RTS) der Steuereinheit (BFS) aktivierbar ist.

10. Wechselrichterschaltung nach Anspruch 9,
**dadurch gekenrizeichnet,**
dass die an der Ansteuerschaltung (RT) vorhandene Relaissteuersignale durch das Testsignal (RTS) für eine so kurze Zeit unterbrochen werden, dass keine Kontakttrennung erfolgt, wobei die Reaktionen auf das Testsignal (RTS) an den Steuerspulen (Sp1, Sp2, Sp3) von der Steuereinheit (BFS) ausgewertet wird.

11. Wechselrichterschaltung nach einem der vorhergehenden Ansprüche,
**gekennzeichnet durch**
eine Ausführung als Photovoltaikwechselrichter (1).

## Claims

1. An inverter circuit for converting a DC voltage into a three-phase network-frequency AC voltage, having a relay circuit, which is situated between a DC/AC converter and a power supply network (NE), and which is implemented as a switch point (4) for the electrical disconnection for active conductors (L1, L2, L3),
**characterized in that** the relay circuit has three double-pole relays (R1, R2, R3), each relay (R1, R2, R3) comprising one control coil (Sp1, Sp2, Sp3) and two relay contacts (K1a, K1b; K2a, K2b; K3a, K3b) which are each associated with one control coil (Sp1, Sp2, Sp3),
in each case, only one relay contact (K1a) of a relay (R1) is connected in series to one relay contact (K2b) of one of the other two relays (R2),
so that two relay contacts (K1a, K2b) to be actuated independently are always provided per active conductor (L1, L2, L3).

2. The inverter circuit according to Claim 1,
**characterized in that** the relay circuit is implemented as an automatic switch point (4) for preventing an unintended feed into a partial or separate network.

3. The inverter circuit according to Claim 1 or 2,
**characterized in that** the relay circuit is integrated in an inverter housing.

4. The inverter circuit according to one of the preceding claims,
**characterized in that** each relay (R1, R2, R3) is implemented as a convertible relay on a circuit board.

5. The inverter circuit according to one of the preceding claims,
**characterized by** a transformer-less embodiment.

6. The inverter circuit according to one of the preceding claims,
**characterized in that** each relay coil (Sp1, Sp2, Sp3) can be actuated separately through an activation circuit (RT) by a control unit (BFS).

7. The inverter circuit according to Claim 6,
**characterized in that** the activation circuit (RT) for each relay coil (Sp1, Sp2, Sp3) comprises an AND gate, in which one gate input is connected to the activation circuit (RT) and another gate input is connected to a watchdog module (W), so that each relay coil (Sp1, Sp2, Sp3) is only actuated if both a set signal (SET K1, SET K2, SET K3) of the control unit (BFS) and also an interruption signal (SAFE BREAK) of the watchdog module are provided simultaneously.

8. The inverter circuit according to Claim 7,
**characterized in that** the control unit (BFS) is permanently monitored by the watchdog module (W).

9. The inverter circuit according to Claim 7 or 8,
**characterized in that** each activation circuit (RT) is activatable by a test signal (RTS) of the control unit (BFS).

10. The inverter circuit according to Claim 9,
**characterized in that** the relay control signals provided at the activation circuit (RT) are interrupted by the test signal (RTS) for such a short time that no contact disconnection occurs, the reactions to the test signal (RTS) at the control coils (Sp1, Sp2, Sp3) being analyzed by the control unit (BFS).

11. The inverter circuit according to one of the preceding claims,
**characterized by** an embodiment as a photovoltaic inverter (1).

## Revendications

1. Circuit onduleur pour transformer une tension continue en une tension alternative triphasée à la fréquence du réseau comportant un circuit en relais monté entre un convertisseur DC/AC et un réseau d'alimentation en énergie (NE) qui est réalisé sous la forme d'un poste de commutation (4) pour la séparation galvanique de conducteurs actifs (L1, L2, L3),
**caractérisé en ce que**
le circuit en relais comporte trois relais bipolaires (R1, R2, R3), chacun de ces relais (R1, R2, R3) comportant une bobine de commande (Sp1, Sp2, Sp3) et deux contacts de relais (K1a, K1b, K2a, K2b, K3a, K3b) respectivement associés à l'une de ces bobines de commande (Sp1, Sp2, Sp3),
un seul contact de relais (k1a) de l'un des relais (R1) étant respectivement monté en série avec un contact de relais (K2b) de l'un des deux autres relais (R2), de sorte que, pour chacun des conducteurs actifs (L1, L2, L3) il y ait toujours deux contacts de relais (k1a, K1b) pouvant être actionnés indépendamment.

2. Circuit onduleur conforme à la revendication 1,
**caractérisé en ce que**
le circuit en relais est réalisé sous la forme d'un poste de commutation (4) automatique pour empêcher une alimentation involontaire dans un sous réseau ou un réseau insulaire.

3. Circuit onduleur conforme à la revendication 1 ou 2,
**caractérisé en ce que**
le circuit en relais est intégré dans un boitier d'onduleur.

4. Circuit onduleur conforme à l'une des revendications précédentes, **caractérisé en ce que**
chacun des relais (R1, R2, R3) est réalisé sous la forme d'un relai amovible sur une platine de commutation.

5. Circuit onduleur conforme à l'une des revendications précédentes, **caractérisé par**
un mode de réalisation sans transformateur.

6. Circuit onduleur conforme à l'une des revendications précédentes, **caractérisé en ce que**
chacune des bobines de relais (Sp1, Sp2, Sp3) peut être actionnée séparément par une unité de commande (BFS) par l'intermédiaire d'un circuit de commande (RT).

7. Circuit onduleur conforme à la revendication 6,
**caractérisé en ce que**
le circuit de commande (RT) comporte une porte et pour chacune des bobines de relais (Sp1, Sp2, Sp3) une entrée de cette porte étant reliée au circuit de commande (RT) tandis qu'une autre entrée de celle-ci est reliée à un dispositif Watchdog (W) de sorte que chacune des bobines de relais (Sp1, Sp2, Sp3) ne soit actionnée qu'en présence simultanée d'un signal de pilotage (SET K1, SET K2, SET K3) de l'unité de commande (BFS) et d'un signal d'interruption (SAFE - BREAK) du dispositif Watchdog.

8. Circuit onduleur conforme à la revendication 7,
**caractérisé en ce que**
l'unité de commande (BFS) est surveillée en permanence par le dispositif Watchdog (W).

9. Circuit onduleur conforme à la revendication 7 ou 8,
**caractérisé en ce que**
chaque circuit de commande (RT) peut être activé par un signal de contrôle (RTS) de l"nité de commande (BFS).

10. Circuit onduleur conforme à la revendication 9,
**caractérisé en ce que**
les signaux de commande de relais présents dans le circuit de commande (RT) sont interrompus par le signal de contrôle (RTS) pendant un laps de temps suffisamment court pour qu'il n'y ait aucune connexion de contact, les réactions au signal de contrôle (RTS) des bobines de relais (Sp11, Sp2, Sp3) étant exploitées par l'unité de commande (BFS).

11. Circuit onduleur conforme à l'une des revendications précédentes, **caractérisé par**
un mode de réalisation en tant qu'onduleur photovoltaïque (1).
